# EUROPÄISCHE PATENTSCHRIFT

(11) **EP 1 145 328 B1**
(45) Veröffentlichungstag und Bekanntmachung des Hinweises auf die Patenterteilung: **01.04.2009**
(21) Anmeldenummer: 99967886.5
(22) Anmeldetag: 17.12.1999
(51) Int. Cl.: H01L 29/808

(54) **SPERRSCHICHT-FELDEFFEKTTRANSISTOR MIT HOCH DOTIERTEN VERBINDUNGSGEBIETEN**
JUNCTION-GATE FIELD-EFFECT TRANSISTOR WITH HIGHLY DOPED CONNECTING AREAS
TRANSISTOR A EFFET DE CHAMP DOTE D'UNE COUCHE D'APPAUVRISSEMENT ET DE ZONES DE CONNEXION HAUTEMENT DOPEES

(30) Priorität: 22.12.1998 DE 19859502
(43) Veröffentlichungstag der Anmeldung: 17.10.2001
(73) Patentinhaber: SiCED Electronics Development GmbH & Co KG, 91052 Erlangen (DE)
(72) Erfinder: TIHANYI, Jenö, D-85551 Kirchheim (DE); MITLEHNER, Heinz, D-91080 Uttenreuth (DE); STEPHANI, Dietrich, D-91088 Bubenreuth (DE)
(74) Vertreter: Maier, Daniel Oliver
(86) Internationale Anmeldenummer: PCT/DE1999/004019
(87) Internationale Veröffentlichungsnummer: WO 2000/038246

(56) Entgegenhaltungen:
- EP-A- 0 732 734
- WO-A-98/49733
- DE-A- 4 309 764
- US-A- 5 323 040
- SHENOY P M ET AL: "A NOVEL P+ POLYSILICON/N-SIC HETEROJUNCTION TRENCH GATE VERTICAL FET" IEEE INTERNATIONAL SYMPOSIUM ON POWER SEMICONDUCTOR DEVICES AND ICS,US,NEW YORK, NY: IEEE, Bd. CONF. 9, 1997, Seiten 365-368, XP000800222 ISBN: 0-7803-3994-0

## Beschreibung

Die Erfindung betrifft einen Sperrschicht-Feldeffekttransistor baut des Oberbegriffes des Anspruchs 1.

Ein solcher Sperrschicht-Feldeffekttransistor ist aus der WO 97/23911 A1 oder auch der WO 98/49733 A1 bekannt. In beiden Dokumenten wird jeweils ein selbstleitender Sperrschicht-Feldeffekttransistor (engl.: Junction Field Effect Transistor = JFET) beschrieben, mit dem sich ein Stromfluß zwischen zwei Elektroden steuern läßt. Insbesondere wird der Strom mit Hilfe des JFETs ein- und ausgeschaltet oder auch auf einen maximalen Wert begrenzt. Andererseits ist der JFET in der Lage, die im Sperrfall anstehende Sperrspannung von mehr als 1000 V aufzunehmen. Wegen der hohen Durchbruchfestigkeit von Siliciumcarbid (SiC) besteht der JFET bevorzugt aus entsprechendem einkristallinen Halbleitermaterial. Der JFET umfaßt ein vergrabenes Inselgebiet, das als Steuergebiet fungiert und das eine Feldabschirmung der einen Elektrode bewirkt.

Die Spannungsfestigkeit wird bei einem unipolaren Transistor, wie dem JFET, unter anderem durch die Dotierung eines Innengebiets bestimmt, das im Sperrfall einen großen Teil der Sperrspannung trägt und im Durchlaßfall den Strom führt. Das Innengebiet wird auch als Driftzone bezeichnet. Je höhere Werte die zu tragende Sperrspannung einerseits annimmt, desto niedriger ist die Dotierung des Innengebiets zu wählen. Um im Durchlaßfall andererseits einen möglichst verlustfreien Stromtransport durch dieses Innengebiet zu gewährleisten, sollte die genannte Dotierung dagegen möglichst hoch sein.

Die beschriebenen gegenläufigen Effekte führen beispielsweise dazu, daß ein in Silicium realisierter Leistungs-Transistor wie z.B. ein spannungsgesteuerter Si-MOSFET (Metal Oxide Semiconductor Field Effect Transistor) oder auch ein Si-JFET üblicherweise nur für eine maximale Sperrspannung von einigen 100 V realisiert wird. Bei einer Auslegung der Dotierung auf eine höhere Sperrspannung steigen die statischen Durchlaßverluste und infolge das Risiko einer Zerstörung des Transistors durch Überhitzung stark an.

Weiterhin ist aus der DE 43 09 764 C2 ein selbstsperrender Leistungs-MOSFET bekannt, der eine Spannung von mehr als 1000 V zu sperren kann. Um bei diesem MOSFET den Durchlaßwiderstand herunterzusetzen, sind in dem Innengebiet zusätzliche p- und n-dotierte Zonen vorgesehen, die eine höhere Dotierungskonzentration aufweisen als das Innengebiet. Damit wird eine Eignung für eine hohe Sperrspannung bei gleichzeitig niedrigen statischen Durchlaßverlusten erreicht. Die angegebenen Gestaltungsmerkmale können sich dabei nur auf einen MOSFET beziehen. Im Gegensatz zu einem JFET benötigt ein MOSFET zur Beeinflussung des Stromflusses nämlich stets ein Steueroxid. Die spezifischen Eigenschaften des Steueroxids, insbesondere die maximal zulässige Feldstärke, haben ebenfalls einen Einfluß auf die maximal mögliche Sperrspannung. Beim MOSFET-Design ist deshalb auch darauf zu achten, daß im Sperrfall keine unzulässig hohen Feldspitzen im Steueroxid entstehen. Dies führt mitunter dazu, daß die Materialeigenschaften des Halbleitermaterials aufgrund der durch das Steueroxid bedingten Vorgaben nur zum Teil ausgenützt werden können.

Aus der EP 732 734 A2 ist außerdem ein zum allgemeinen Stand der Technik zählender sogenannter Static Induction Transistor (SIT) auf Silicium-Basis bekannt. Der offenbarte SIT hat ein am Boden eines Grabens angeordnetes Steuergebiet, das jedoch nur eine unvollständige Abschirmung eines neben dem Graben angeordneten Source-Kontaktgebiets bewirkt. Außerdem sind die seitlichen Grabenränder mit einem Oxid bedeckt. Deshalb ist auch dieser SIT in seiner Eignung für eine hohe Sperrspannung begrenzt.

Der Erfindung liegt nun die Aufgabe zugrunde, einen Leistungs-Transistor anzugeben, der zugleich für eine hohe Sperrspannung geeignet ist und außerdem im Durchlaßfall niedrige statische Verluste aufweist. Darüber hinaus soll der Leistungs-Transistor ohne ein Steueroxid auskommen.

Gelöst wird diese Aufgabe durch einen Sperrschicht-Feldeffekttransistor, die in Patentanspruch 1 angegebenen Merkmale aufweist.

Die Erfindung beruht dabei auf der Erkenntnis, daß der Bahnwiderstand im Innengebiet des Sperrschicht-Feldeffekttransistors (JFET) durch mindestens ein höher als das Innengebiet dotiertes erstes Verbindungsgebiet verringert werden kann. Das erste Verbindungsgebiet weist den gleichen Leitungstyp wie das Innengebiet auf und es erstreckt sich zumindest teilweise in den Bereich des JFETs, der im Durchlaßfall von einem Strom durchflossen wird. Um einen möglichst langen Strompfad mit niedrigem Bahnwiderstand zu erhalten, ist das erste Verbindungsgebiet direkt an das Source-Kontaktgebiet angeschlossen. Die Anbindung erfolgt dabei niederohmig. Damit ergibt sich für den im Durchlaßfall zwischen dem Source-Kontaktgebiet und dem Drain-Kontaktgebiet fließenden Strom ein deutlich verlustärmerer Pfad als bei einem Stromfluß über das niedriger dotierte Innengebiet.

Im Sperrfall kommt eine durch die höhere Dotierung bedingte niedrigere Spannungsfestigkeit des ersten Verbindungsgebiets dennoch nicht zum Tragen. Der Einfluß des ersten Verbindungsgebiets wird nämlich durch das zweite Verbindungsgebiet, das den zweiten Leitungstyp aufweist, zumindest teilweise kompensiert. Bei einer hohen Sperrspannung sind in den inneren Teilen des ersten und des zweiten Verbindungsgebiets praktisch keine freien Ladungsträger mehr vorhanden. Sie sind nämlich ab einem bestimmten Wert der Sperrspannung vollständig ausgeräumt, so daß nur die Raumladungen zurückbleiben. Dadurch verlaufen die Äquipotentiallinien des elektrischen Felds ab diesem Sperrspannungswert praktisch parallel zur ersten Oberfläche durch den Halbleiterbereich. Es stellt sich also eine elektrische Feldverteilung ein, als ob die Verbindungsgebiete überhaupt nicht vorhanden seien. Das Sperrverhalten des JFETs wird durch die beschriebene Maßnahme zur Reduzierung des Bahnwiderstands im Durchlaßfall folglich nicht beeinträchtigt. Die maximale Sperrspannung, die der JFET tragen kann, bestimmt sich genau wie beim Stand der Technik nach der Dotierung des Innengebiets.

Bei dem JFET wird der Stromfluß durch mindestens eine Sperrschicht zwischen Halbleitergebieten mit entgegengesetzten Leitungstyp gesteuert. Ein Steueroxid ist hierfür nicht notwendig. Die bei einem MOSFET möglichen Feldspitzen im Steueroxid können bei dem JFET prinzipiell nicht auftreten.

Vorteilhafte Ausgestaltungen des Sperrschicht-Feldeffekttransistors gemäß der Erfindung ergeben sich aus den abhängigen Ansprüchen.

Eine bevorzugte Ausführungsform betrifft die Anordnung der inneren Teile des ersten und zweiten Verbindungsgebiets innerhalb des Halbleiterbereichs. In dem Halbleiterbereich befindet sich eine Ausnehmung, die sich von einer zweiten Oberfläche des Halbleiterbereichs ausgehend in den Halbleiterbereich erstreckt. Die zweite Oberfläche ist dabei auf einer der ersten Oberfläche gegenüberliegenden Seite des Halbleiterbereichs angeordnet. Die Ausnehmung kann beispielsweise in Form eines Grabens in den Halbleiterbereich geätzt werden. In diesen Graben werden die inneren Teile des ersten und des zweiten Verbindungsgebietes eingebracht. Dies kann entweder über ein epitaktisches Aufwachsen undotierter oder nur schwach dotierter Schichten mit nachfolgender Ionenimplantation oder auch über ein unmittelbares epitaktisches Wachstum entsprechend n- und p-dotierten Schichten erfolgen. Entsprechend dem Stromfluß zwischen dem Source-Kontaktgebiet und dem Drain-Kontaktgebiet durch den Halbleiterbereich verlaufen sowohl der Graben als auch die darin befindlichen inneren Teile des ersten und zweiten Verbindungsgebiets senkrecht zur ersten Oberfläche des Halbleiterbereichs.

Vorteilhaft ist weiterhin eine Ausführungsform des Sperrschicht-Feldeffekttransistors, bei der der mindestens eine innere Teil des ersten Verbindungsgebiets an Ränder der Ausnehmung angrenzt. Der innere Teil des ersten Verbindungsgebiets kann dabei sowohl in unmittelbarer Nachbarschaft zu den seitlichen Rändern als auch zu dem unteren Rand der Ausnehmung angeordnet sein. Dadurch grenzt der innere Teil des ersten Verbindungsgebiets an das Innengebiet des Halbleiterbereichs, das den gleichen Leitungstyp, wenn auch in schwächerer Dotierungskonzentration aufweist. Damit ergibt sich eine günstigere Feldverteilung und eine bessere Ankopplung als bei einer Ausführungsform, bei der der mindestens eine innere Teil des zweiten Verbindungsgebiets an Ränder der Ausnehmung angrenzt.

Eine vorteilhafte Ausführungsform des Sperrschicht-Feldeffekttransistors zeichnet sich dadurch aus, daß zu jedem senkrecht zur ersten Oberfläche verlaufenden inneren Teil des ersten Verbindungsgebiets ein dazu parallel verlaufender innerer Teil des zweiten Verbindungsgebiets existiert. Durch diese Zuordnung erreicht man, daß im Sperrfall eine möglichst optimale Kompensation von Raumladungen innerhalb der beiden Verbindungsgebiete stattfindet. Dadurch stellt sich dann der vorteilhafte, zur ersten Oberfläche parallel gerichtete Verlauf der Äquipotentiallinien innerhalb des gesamten Halbleiterbereichs ein.

Die besagte Kompensation gegenseitiger Raumladungen zwischen den beiden Verbindungsgebieten wird in einer weiteren vorteilhaften Ausführungsform zusätzlich optimiert, indem die einander zugeordneten inneren Teile des ersten und zweiten Verbindungsgebiets direkt aneinandergrenzen. Je näher die entsprechenden Raumladungszonen mit entgegengesetzter Polarität beieinanderliegen, um so besser ist die Kompensation.

In dem erfindungsgemäßen Leistung-Transistor erstreckt sich das erste Verbindungsgebiet bis zum Drain-Kontaktgebiet, das seinerseits an die erste Oberfläche des Halbleiterbereichs angrenzt. Dadurch wird auch das Drain-Kontaktgebiet niederohmig an das erste Verbindungsgebiet angeschlossen. Es ergibt sich ein durchgehender Strompfad zwischen dem Source-Kontaktgebiet und dem Drain-Kontaktgebiet, der eine höhere Dotierung und somit einen niedrigeren Bahnwiderstand als das Innengebiet aufweist. Aufgrund der beschriebenen gegenseitigen Kompensation von Raumladungen zwischen dem ersten und dem zweiten Verbindungsgebiet resultiert auch in dieser vorteilhaften Ausgestaltungsform keine Verschlechterung im Sperrverhalten.

Vorteilhaft ist weiterhin eine Ausführungsform, bei der zumindest der innere Teil des ersten Verbindungsgebiets eine Dotierungskonzentration aufweist, die der Durchbruchsladung des verwendeten Halbleitermaterials zumindest weitgehend entspricht. Unter der Durchbruchsladung versteht man in diesem Zusammenhang diejenige Raumladung, die erforderlich ist, damit sich an einem p-n-Übergang eine maximale Feldstärke ausbildet, die der kritischen Feldstärke des verwendeten Halbleitermaterials entspricht. Steigt die Feldstärke über diesen materialspezifischen Wert der kritischen Feldstärke, so kommt es zu einem sogenannten Avalanche-Durchbruch. Hieraus leitet sich der obengenannte Begriff "Durchbruchsladung" ab. Die sich ausbildende maximale Feldstärke ist proportional zu der die Raumladung bestimmenden Dotierungskonzentration. Deshalb weist der innere Teil des ersten Verbindungsgebiets also gerade dann seine maximal zulässige Dotierungskonzentration auf, wenn er gemäß der kritischen Feldstärke oder, was analog dazu ist, gemäß der Durchbruchsladung dotiert ist. Da der Driftwiderstand mit steigender Dotierungskonzentration sinkt, erhält man mit der obengenannten Dotierungskonzentration auch die minimal möglichen statischen Durchlaßverluste.

In dem erfindungsgemäßen Sperrschicht-Feldeffekttransistor besitzt der zumindest der innere Teil des zweiten Verbindungsgebiets eine Dotierungskonzentration, die der des inneren Teils des ersten Verbindungsgebiets zumindest weitgehend entspricht. Durch eine gleiche Dotierungskonzentration in beiden Verbindungsgebieten wird erreicht, daß bei maximaler Sperrspannung jeder ortsfesten Raumladung des einen Verbindungsgebiets eine Raumladungszone des anderen Verbindungsgebiets zugeordnet werden kann. Dadurch ergibt sich die größtmögliche gegenseitige Kompensation.

In einer anderen vorteilhaften Ausführungsform besteht der Sperrschicht-Feldeffekttransistor wenigstens teilweise aus einem Halbleitermaterial, das einen Bandabstand von wenigstens 2 eV aufweist. Beispiele für ein solches Halbleitermaterial sind Diamant, Galliumnitrid (GaN), Indiumphosphid (InP) und Siliciumcarbid (SiC). Vor allem letzteres eignet sich aufgrund dem extrem niedrigen intrinsischen Ladungsträgerkonzentration (= Ladungsträgerkonzentration ohne Dotierung) und der sehr niedrigen materialspezifischen Durchlaßverluste besonders gut. Die genannten Halbleitermaterialien weisen außerdem eine im Vergleich zu dem "Universalhalbleiter" Silicium (Si) deutlich höhere Durchbruchfestigkeit auf. Deshalb kann ein mit einem der genannten Halbleiter realisierter JFET bei ansonsten gleicher Geometrie eine höhere Sperrspannung tragen als ein Si-JFET. Das bevorzugte Halbleitermaterial ist Siliciumcarbid, insbesondere einkristallines Siliciumcarbid vom 3C-, 4H-, 6H- oder 15R-Polytyp, da SiC überragende elektronische und thermische Eigenschaften besitzt.

Bei einem Sperrschicht-Feldeffekttransistor aus Siliciumcarbid weist der innere Teil des ersten Verbindungsgebiets bevorzugt eine Dotierungskonzentration von höchstens 1·10¹³ cm⁻² auf. Dieser Wert ist dabei bezogen auf eine fiktive Fläche, die senkrecht zur ersten Oberfläche angeordnet ist.

Prinzipiell läßt sich der Sperrschicht-Feldeffekttransistor aber auch mit dem Halbleitermaterial Silicium realisieren. Silicium ist ein hochverfügbares Halbleitermaterial, das in bester einkristalliner Qualität erhältlich ist. Für viele Anwendungen der Leistungselektronik ist außerdem die bei vorgegebener maximaler Sperrspannung mit Silicium erzielbare Verlustleistung klein genug.

Bei einer Realisierung des Sperrschicht-Feldeffekttransistors in Silicium weist das erste Verbindungsgebiet eine bevorzugte Dotierungskonzentration von höchstens 1,5·10¹² cm⁻² auf. Diese Konzentration ist wiederum auf eine fiktive Fläche bezogen, die senkrecht zur ersten Oberfläche verläuft.

Bevorzugt ist eine Ausführungsform, bei der sich das Steuergebiet längs einer zweiten Oberfläche des Halbleiterbereichs erstreckt. Die zweite Oberfläche befindet sich an einer der ersten Oberfläche gegenüberliegenden Seite des Halbleiterbereichs.

Vorteilhaft ist eine Ausführungsform des Sperrschicht-Feldeffekttransistors, bei der die Gate-Elektrode sowohl das Steuergebiet als auch das zweite Verbindungsgebiet ohmsch kontaktiert. Damit eröffnet sich die Möglichkeit, über ein einziges an der gemeinsamen Gate-Elektrode anstehendes Steuerpotential den Stromfluß und auch die Feldverteilung zu beeinflussen.

Vorteilhaft ist der Sperrschicht-Feldeffekttransistor so ausgebildet, daß auf dem Halbleiterbereich über dem Steuergebiet ein Schichtstapel bestehend aus einem äußeren Teil des ersten Verbindungsgebiets, dem Source-Kontaktgebiet und aus einem äußeren Teil des zweiten Verbindungsgebiets angeordnet ist. Der äußere Teil des ersten Verbindungsgebiets grenzt dabei an den Halbleiterbereich an. Vorteilhaft ist der Schichtstapel weiterhin so aufgebaut, daß sich eine Projektion des Steuergebiets und eine Projektion des äußeren Teils des zweiten Verbindungsgebiets zumindest teilweise überlappen. Eine gemeinsame Richtung der Projektionen verläuft dabei senkrecht zur ersten Oberfläche. Im Bereich der Überlappung ergibt sich dann innerhalb des Source-Kontaktgebiets und des äußeren Teils des ersten Verbindungsgebiets eine Kanalzone, über die der Stromfluß gesteuert werden kann. An p-n-Übergängen zwischen dem äußeren Teil des zweiten Verbindungsgebiets und dem Source-Kontaktgebiet sowie zwischen dem Steuergebiet und dem äußeren Teil des ersten Verbindungsgebiets bilden sich Raumladungszonen (= Sperrschichtzonen), die die Kanalzone begrenzen. Durch ein an dem zweiten Verbindungsgebiet und dem Steuergebiet anstehendes Steuerpotential kann die Ausdehnung der Raumladungszonen und damit der Stromfluß beeinflußt werden.

Bevorzugte Ausführungsbeispiele eines erfindungsgemäßen JFETs werden nunmehr anhand der Zeichnung näher erläutert. Zur Verdeutlichung ist die Zeichnung nicht maßstäblich ausgeführt, und gewisse Merkmale sind schematisiert dargestellt. Im einzelnen zeigen die:
- Figur 1: einen Sperrschicht-Feldeffekttransistor mit einem höher dotierten Verbindungsgebiet,
- Figuren 2 bis 6: eine Herstellung der Verbindungsgebiete des Sperrschicht-Feldeffekttransistors von Figur 1 mittels epitaktischem Schichtwachstum und nachgeschalteter Ionenimplantation,
- Figuren 7 und 8: eine Herstellung der Verbindungsgebiete des Sperrschicht-Feldeffekttransistors von Figur 1 mittels epitaktischem Wachstum dotierter Schichten und
- Figur 9: Äquipotentiallinien innerhalb des Sperrschicht-Feldeffekttransistors von Figur 1 bei verschiedenen Sperrspannungen.

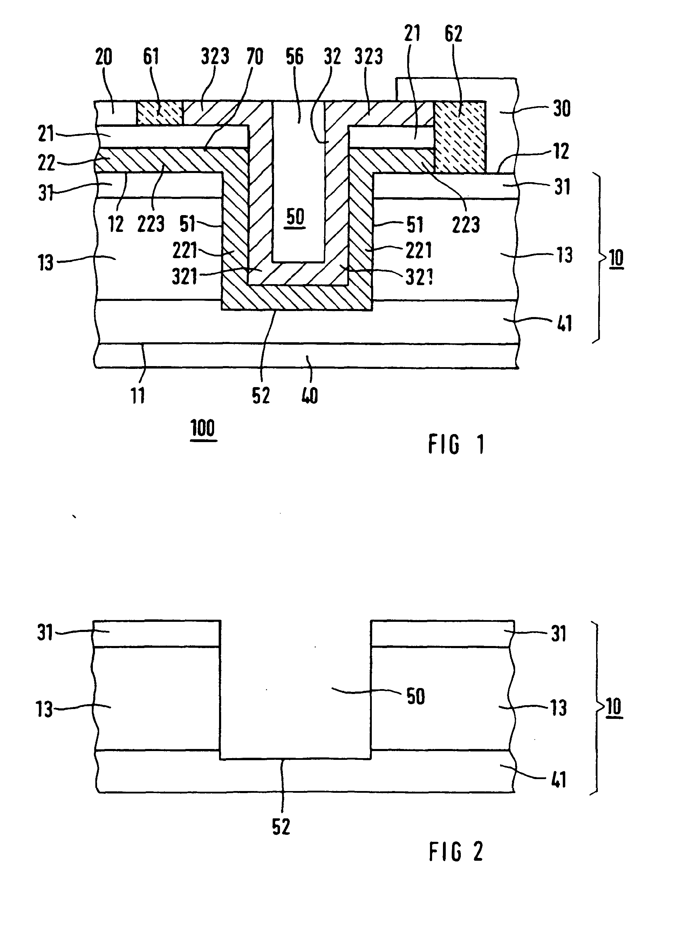

Einander entsprechende Teile sind in den Figuren 1 bis 9 mit denselben Bezugszeichen versehen.

In Figur 1 ist ein selbstleitender Sperrschicht-Feldeffekttransistor (Junction Field Effect Transistor = JFET) 100 dargestellt, der im wesentlichen aus einem Halbleiterbereich 10 sowie verschiedenen darauf aufgebrachten halbleitenden Schichten und Elektroden besteht. Der Halbleiterbereich 10 setzt sich aus einem hoch n-dotierten Drain-Kontaktgebiet 41, einem niedrig n-dotierten Innengebiet 13 und einem darüber angeordneten hoch p-dotierten Steuergebiet 31 zusammen.

Das Drain-Kontaktgebiet 41 ist an einer ersten Außenseite bzw. Oberfläche 11 des Halbleiterbereichs 10 über eine Drain-Elektrode 40 kontaktiert. An einer der ersten Oberfläche 11 gegenüberliegenden zweiten Oberfläche 12 des Halbleiterbereichs 10 befindet sich eine Ausnehmung 50, die in Form eines Grabens in den Halbleiterbereich 10 hineinreicht. Die Ausnehmung 50 besitzt seitliche Ränder 51 und einen unteren Rand 52. Der untere Rand 52 liegt im Bereich des Drain-Kontaktgebiets 41.

In das Innere der Ausnehmung 50 ragt ein erstes Verbindungsgebiet 22. Es ist n-dotiert und enthält innere Teile 221, die jeweils senkrecht zur ersten Oberfläche 11 längs den seitlichen Rändern 51 der Ausnehmung 50 verlaufen. Außerhalb der Ausnehmung 50 befindet sich über dem Steuergebiet 31 ein äußerer Teil 223 des ersten Verbindungsgebiets 22. Auf diesem äußeren Teil 223 des ersten Verbindungsgebiets 22 ist ein Source-Kontaktgebiet 21 angeordnet, das auf einer Seite der Ausnehmung 50 über eine Source-Elektrode 20 kontaktiert ist.

Im Inneren der Ausnehmung 50 ist an das erste Verbindungsgebiet 22 angrenzend ein zweites Verbindungsgebiet 32 vorgesehen. Das zweite Verbindungsgebiet 32 umfaßt wiederum innere Teile 321, die ebenfalls senkrecht zur ersten Oberfläche 11 des Halbleiterbereichs 10 verlaufen, sowie einen äußeren Teil 323, der auf dem Source-Kontaktgebiet 21 angeordnet ist. Das zweite Verbindungsgebiet 32 ist p-dotiert. Auf dem Source-Kontaktgebiet 21 ist zwischen der Source-Elektrode 20 und dem äußeren Teil 323 des zweiten Verbindungsgebiets 32 ein erstes Isolationsgebiet 61 vorgesehen. Auf der von der Source-Elektrode 20 abgewandten Seite der Ausnehmung 50 befindet sich eine Gate-Elektrode 30. Diese kontaktiert sowohl das Steuergebiet 31 an der zweiten Oberfläche 12 des Halbleiterbereichs 10 als auch das zweite Verbindungsgebiet 32 an seinem äußeren Teil 323. Ein zweites Isolationsgebiet 62 verhindert einen elektrischen Kontakt zwischen dem Source-Kontaktgebiet 21 und der Gate-Elektrode 30.

Im Bereich der Ausnehmung 50 umschließt das zweite Verbindungsgebiet 32 eine Füllzone 56, die mit undotiertem Halbleitermaterial gefüllt ist. Anstelle von undotiertem Halbleitermaterial kann jedoch genausogut schwach dotiertes Halbleitermaterial verwendet werden.

Als Halbleitermaterial ist im dargestellten Ausführungsbeispiel für alle halbleitenden Bereiche Siliciumcarbid (SiC) vorgesehen. Dieses Halbleitermaterial ist aufgrund seiner hervorragenden Eigenschaften besonders dann geeignet, wenn wie im vorliegenden Fall eine hohe Sperrspannungsfestigkeit, insbesondere über 1000 V, gefordert ist. Die Sperrspannungsfestigkeit wird insbesondere durch die geometrische Abmessung und auch durch die Dotierungskonzentration des Innengebiets 13 bestimmt. Je höher die Dotierungskonzentration gewählt wird, um so niedriger ist eine maximale Sperrspannung Uₘₐₓ, die der Sperrschicht-Feldeffekttransistor 100 tragen kann. Diese Abhängigkeit der maximalen Sperrspannung Uₘₐₓ von der Dotierungskonzentration des Innengebiets 13 wird durch die folgenden Angaben verdeutlicht. Für eine maximale Sperrspannung Uₘₐₓ von etwa 60 V wird das Innengebiet 13 in einer Größenordnung von etwa 2·10¹⁷ cm⁻³, für eine maximale Sperrspannung Uₘₐₓ von etwa 700 V in einer Größenordnung von etwa 2·10¹⁶ cm⁻³ und für eine maximale Sperrspannung Uₘₐₓ von etwa 1200 V in einer Größenordnung von etwa 6·10¹⁵ cm⁻³ dotiert. Um einen möglichst niederohmigen Übergang zwischen den halbleitenden Bereichen und den Elektroden zu ermöglichen, wird insbesondere für das Source-Kontaktgebiet 21 und das Drain-Kontaktgebiet 11 eine Dotierungskonzentration von über 1·10¹⁹ cm⁻³ vorgesehen. Das Steuergebiet 31 ist in der Größenordnung zwischen 1·10¹⁸ cm⁻³ und 2·10¹⁹ cm⁻³ dotiert. In SiC bevorzugte Dotierstoffe sind Bor und Aluminium für eine p-Dotierung und Stickstoff für eine n-Dotierung. Die genannten Dotierungskonzentrationen gelten alle jeweils für das Halbleitermaterial Siliciumcarbid.

In einem anderen, nicht dargestellten Ausführungsbeispiel, bei dem z.B. eine niedrigere maximale Sperrspannung Uₘₐₓ gefordert ist, kann als Halbleitermaterial jedoch auch Silicium zum Einsatz kommen. Dabei sind die oben für SiC angegebenen Dotierungskonzentrationen im allgemeinen jeweils durch etwa 100 zu dividieren (um zwei Größenordnungen kleiner).

Das erste und zweite Isolationsgebiet 61 und 62 bestehen aus einer Isolationsschicht, insbesondere aus einer Oxidschicht. Für diese Isolationsschicht wird vorzugsweise das Dielektrikum Siliciumdioxid (SiO₂) verwendet, das insbesondere thermisch gewachsen wird. Thermisches Oxid weist hervorragende Isolationseigenschaften auf und kann insbesondere auch auf Siliciumcarbid durch Trocken- oder Naßoxidation bei Temperaturen über 1000°C erzeugt werden. Für die Isolationsschicht kann jedoch auch ein anderes Dielektrikum, wie z.B. das nichtoxidische Siliciumnitrid (Si₃N₄), verwendet werden.

Die beiden Isolationsgebiete 61 und 62 dienen bei dem dargestellten Sperrschicht-Feldeffekttransistor 100 jeweils ausschließlich der elektrischen Isolation. Sie haben keine dem Steueroxid eines MOSFETs vergleichbare Funktion bei der Stromsteuerung. Damit spielt die Frage von unzulässig hohen Werten der elektrischen Feldstärke innerhalb dieser beiden Isolationsgebiete 61 und 62 keine entscheidende Rolle. Der Qualität der Isolationsgebiete 61 und 62 kommt dann folglich auch keine vergleichbar hohe Bedeutung wie bei einem MOSFET zu. Da die beiden Isolationsgebiete 61 und 62 für die Stromsteuerung keine Relevanz haben, ist auch der Sperrschicht-Feldeffekttransistor 100 in seinem Stromsteuerungsverhalten weitgehend temperaturunabhängig. Demgegenüber besitzt ein MOSFET eine im wesentlichen durch das Steueroxid hervorgerufene, deutlich höhere Temperaturempfindlichkeit.

Als Material für die Source-Elektrode 20, die Drain-Elektrode 40 und die Gate-Elektrode 30 kommen Polysilicium oder ein Metall, vorzugsweise Nickel (Ni), Aluminium (Al), Tantal (Ta), Titan (Ti) oder Wolfram (W) in Frage. Als Elektrodenmaterial kann weiterhin auch eine Verbindung oder eine Legierung, die eines der vorstehend genannten Metalle enthält, verwendet werden. Das Elektrodenmaterial wird entweder durch Aufdampfen oder durch Sputtern aufgebracht.

Für einen Stromfluß über den Sperrschicht-Feldeffekttransistor 100 zwischen der Source-Elektrode 20 und der Drain-Elektrode 40 ist im wesentlichen das n-dotierte erste Verbindungsgebiet 22 vorgesehen. Dieses ist entsprechend der Durchbruchsladung von Siliciumcarbid dotiert. Die Durchbruchsladung ist eine materialspezifische Größe und mit der kritischen elektrischen Feldstärke in dem Halbleitermaterial verknüpft, ab der es zu einem Avalanche-Durchbruch kommen kann.

Die kritische Feldstärke von SiC liegt bei etwa 2 MV/cm. Bei einer Realisierung in SiC haben dann zumindest die inneren Teile 221 des Verbindungsgebiets 22 bezogen auf eine Fläche, die sowohl zur ersten Oberfläche 11 als auch zur Zeichenebene von Figur 1 senkrecht ist, eine dieser kritischen Feldstärke entsprechende Dotierungskonzentration von etwa 1·10¹³ cm⁻².

Demgegenüber weisen die inneren Teile 221 des Verbindungsgebiets 22 bei einer nicht explizit dargestellten Realisierung des JFETs in Silicium (Si) eine der kritischen Feldstärke von Silicium entsprechende Dotierungskonzentration von etwa 1,5·10¹² cm⁻² auf.

Multipliziert man bei dem SiC-JFET von Figur 1 die obengenannte, auf eine Fläche bezogene Dotierungskonzentration mit der entsprechenden geometrischen Ausdehnung in Richtung der Flächennormalen - im Ausführungsbeispiel von Figur 1 entspricht dies der Dicke des Verbindungsgebiets 22 innerhalb der Ausnehmung 50 -, so erhält man eine räumliche Dotierungskonzentration von etwa 1·10¹⁸ cm⁻³. Hierbei ist eine Dicke des ersten Verbindungsgebiets 22 von 100 nm zugrunde gelegt. Diese Dotierungskonzentration liegt deutlich über der für die maximale Sperrspannung Uₘₐₓ maßgeblichen Dotierungskonzentration des Innengebiets 13. Für eine maximale Sperrspannung Uₘₐₓ von beispielsweise 2000 V ist in dem Innengebiet 13 in SiC eine Dotierungskonzentration in der Größenordnung von 10¹⁵ cm⁻³ , insbesondere von < 5·10¹⁵ cm⁻³, erforderlich.

Durch die hohe Dotierung in dem ersten Verbindungsgebiet 22 sinkt der Drift- oder auch Bahnwiderstand für den elektrischen Strom im Durchlaßfall erheblich. Gleichzeitig hat die hohe Dotierungskonzentration in dem ersten Verbindungsgebiet 22 jedoch auch keine nachteiligen Auswirkungen auf das Sperrverhalten. Das zweite Verbindungsgebiet 32 weist zu diesem Zweck nämlich eine in etwa gleiche Dotierungskonzentration wie das erste Verbindungsgebiet 22 auf, jedoch mit einem Dotierstoff, der den entgegengesetzten Leitungstyp hervorruft. Die Einflüsse der Donator- und Akzeptoratome im ersten und zweiten Verbindungsgebiet 22 bzw. 32 kompensieren sich bei einem hohen Sperrspannungswert dann gegenseitig. In diesem Fall sind beide Verbindungsgebiete 22 und 32 komplett ausgeräumt, d.h. es existieren keine freien Ladungsträger mehr. Die Äquipotentiallinien des elektrischen Feldes verlaufen dann praktisch parallel zur ersten Oberfläche 11. Damit besteht im Sperrfall kein Unterschied im Verhalten zu einem Sperrschicht-Feldeffekttransistor ohne jegliche Verbindungsgebiete. Gleichzeitig reduzieren sich die auf eine Flächenbelegung im Halbleiterbereich 10 bezogenen statischen Durchlaßverluste dank des höher dotierten ersten Verbindungsgebiets 22 jedoch erheblich. Dadurch eröffnet sich die Möglichkeit, den Sperrschicht-Feldeffekttransistor 100 mit einem geringeren Platzbedarf zu realisieren.

Der Sperrschicht-Feldeffekttransistor 100 kann über ein an der Gate-Elektrode 30 anstehendes Steuerpotential zwischen einem leitenden und einem sperrenden Zustand umgeschaltet werden. Ein in den Sperrzustand umschaltendes Steuerpotential bewirkt, daß eine Kanalzone 70, die sich innerhalb des Source-Kontaktgebiets 21 und des äußeren Teils.223 des Verbindungsgebiets 22 befindet, durch Raumladungszonen von p-n-Übergängen komplett abgeschnürt oder überdeckt wird. Damit wird die Kanalzone 70 für den elektrischen Strom unpassierbar. Die Kanalzone 70 wird an den äußeren Rändern durch das Steuergebiet 31 und durch den äußeren Teil 323 des zweiten Verbindungsgebiets 32 begrenzt. Projiziert man das Steuergebiet 31 und den äußeren Teil 323 des zweiten Verbindungsgebietes 32 senkrecht zur ersten Oberfläche 11 des Halbleiterbereichs 10 in eine gemeinsame Ebene, so überlappen sich die beiden Projektionen teilweise. Das Kanalgebiet 70 liegt genau im Bereich dieser Überlappung.

Im Unterschied zu dem in Figur 1 gezeigten Sperrschicht-Feldeffekttransistor 100 ist auch eine andere Ausführungsform möglich, bei der das Steuergebiet 31 als vergrabenes Inselgebiet (= Buried Gate) vorliegt.

Zur Erhöhung der Stromtragfähigkeit können darüber hinaus auch mehrere Sperrschicht-Feldeffekttransistoren 100 auf einem Halbleitersubstrat nebeneinander angeordnet sein. Der in Figur 1 gezeigte Sperrschicht-Feldeffekttransistor 100 stellt in so einer Anordnung dann eine Einzelzelle dar, wobei alle Einzelzellen auf dem Halbleitersubstrat parallel geschaltet sind. Die Stromtragfähigkeit kann außerdem auch dadurch erhöht werden, daß innerhalb eines Sperrschicht-Feldeffekttransistors 100 mehrere Ausnehmungen 50 vorgesehen sind, die jeweils erste und zweite Verbindungsgebiete 22 bzw. 32 beinhalten. Auch können in einer einzigen Ausnehmung 50 mehrere erste und zweite Verbindungsgebiete 22 bzw. 32 angeordnet sein.

In den Figuren 2 bis 6 ist ein erstes Verfahren zur Herstellung der beiden Verbindungsgebiete 22 bzw. 32 dargestellt.

Ausgangspunkt ist der in Figur 2 gezeigte, den Halbleiterbereich 10 des fertigen JFETs bildende und nachfolgend mit dessen Bezugszeichen gekennzeichnete Halbleiterkörper. Er enthält bereits die unterschiedlichen Dotierungen für das Drain-Kontaktgebiet 41, das Innengebiet 13 und das Steuergebiet 31. Mittels der aus der Speichertechnologie bekannten Trench-Technik wird die Ausnehmung 50 in den Halbleiterkörper 10 mit vorgegebener Tiefe geätzt. Der untere Rand 52 der Ausnehmung 50 befindet sich innerhalb des Drain-Kontaktgebiets 41. Die Tiefe der Ausnehmung 50 hängt dabei sowohl vom verwendeten Halbleitermaterial als auch von der geforderten maximalen Sperrspannung Uₘₐₓ ab, da diese Parameter die geometrische Abmessung des Innengebiets 13 bestimmen. Für eine maximale Sperrspannung Uₘₐₓ von etwa 2000 V und dem hier verwendeten SiC beträgt die durch das Innengebiet 13 bestimmte Tiefe der Ausnehmung 50 mindestens etwa 20 µm. Für einen nicht dargestellten Sperrschicht-Feldeffekttransistor 100 aus dem Halbleitermaterial Silicium, der beispielsweise für eine maximale Sperrspannung Uₘₐₓ von etwa 600 V dimensioniert ist, beträgt die Tiefe der Ausnehmung 50 mindestens 50 µm. Bei einer höheren maximalen Sperrspannung Uₘₐₓ ist ein entsprechend größeres Innengebiet 13 zum Abbau der Sperrspannung erforderlich. Bei einem Si-JFET kann die Tiefe der Ausnehmung 50 daher auch mehr als 80 µm betragen.

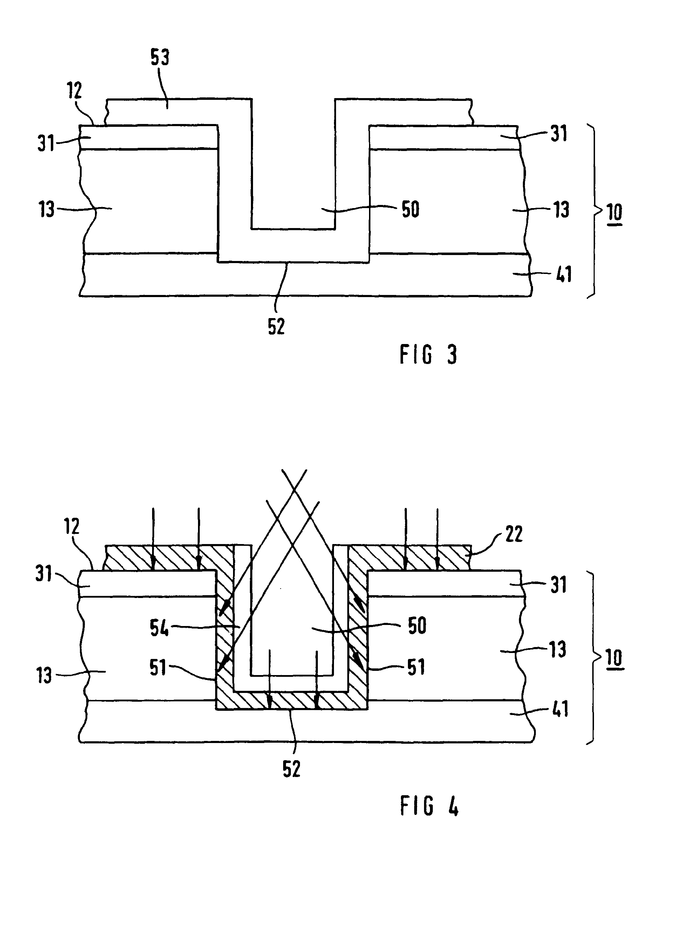

Ausgehend von dem in Figur 2 dargestellten Halbleiterkörper 10 mit eingeätzter Ausnehmung 50 läßt man eine erste undotierte Epitaxieschicht 53 aus dem Grundmaterial für das erste Verbindungsgebiet 22 in der Ausnehmung 50 und auf der zweiten Oberfläche 12 aufwachsen (Figur 3). Anstelle einer undotierten kann auch eine schwachdotierte Epitaxieschicht aufgebracht werden.

In Figur 4 ist eine sich anschließende Ionenimplantation der ersten undotierten Epitaxieschicht 53 dargestellt. Damit entsteht das n-dotierte erste Verbindungsgebiet 22. Die Ionenimplantation findet dabei mit unterschiedlichen Neigungswinkeln bezüglich der zweiten Oberfläche 12 des Halbleiterkörpers 10 statt. Die Bereiche der ersten undotierten Epitaxieschicht 53, die sich an der zweiten Oberfläche 12 des Halbleiterkörpers 10 und am unteren Rand 52 der Ausnehmung 50 befinden, werden senkrecht zur zweiten Oberfläche 12 implantiert. Die an die seitlichen Ränder 51 der Ausnehmung 50 angrenzenden Bereiche der ersten undotierten Epitaxieschicht 53 werden dagegen mittels Schrägimplantation dotiert. Die Wirkungsrichtung der Ionenimplantation ist in Figur 4 durch die Pfeile angedeutet.

Die Schrägimplantation hat zur Folge, daß auch die Breite der Ausnehmung 50 mit zunehmender Tiefe ansteigt. Im Sinne eines möglichst geringen Platzbedarfs ist damit eine möglichst geringe Tiefe der Ausnehmung 50 günstig. In dieser Hinsicht bietet ein in SiC realisierter Sperrschicht-Feldeffekttransistor 100 Vorteile, da er selbst bei einer hohen maximalen Sperrspannung Uₘₐₓ mit einer relativ flachen Graben-Ätzung auskommt. Für eine maximale Sperrspannung Uₘₐₓ von beispielsweise 2000 V hat die Ausnehmung 50 in SiC nur eine Tiefe von 20 µm.

Innerhalb der Ausnehmung 50 werden die Ionen so in die undotierte erste Epitaxieschicht 53 implantiert, daß sich nur in unmittelbarer Nachbarschaft zu den seitlichen Rändern 51 und dem unteren Rand 52 der Ausnehmung 50 das n-dotierte erste Verbindungsgebiet 22 bildet. Ein von den Rändern 51 bzw. 52 der Ausnehmung 50 abgewandter Bereich der ersten undotierten Epitaxieschicht 53 bleibt dagegen undotiert und bildet eine Zwischenzone 54, da in SiC bei einer Temperatur ≤ 1700°C praktisch keine Diffusion von Dopanden stattfindet.

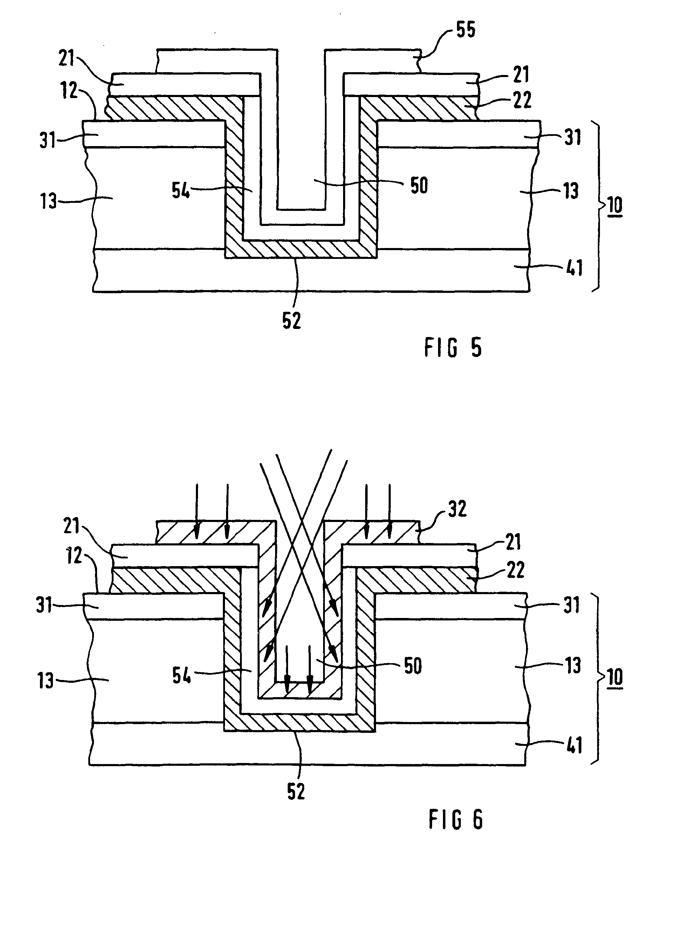

Auf das erste Verbindungsgebiet 22 wird außerhalb der Ausnehmung 50 das n-dotierte Source-Kontaktgebiet 21 epitaktisch aufgebracht. Anschließend läßt man eine weitere undotierte zweite Epitaxieschicht 55 auf das Source-Kontaktgebiet 21 und die Zwischenzone 54 aufwachsen (Figur 5).

In Figur 6 ist die p-Dotierung der zweiten undotierten Epitaxieschicht 55 mittels Ionenimplantation dargestellt. Die Ionenimplantation mit Akzeptoren erfolgt dabei analog zu der in Figur 4 dargestellten Ionenimplantation mit Donatoren. Nach einer gegebenenfalls zur Aktivierung der implantierten Ionen und zur Ausheilung von entstandenen Gitterdefekten durchgeführten Temperung liegen dann das n-dotierte erste Verbindungsgebiet 22 und das p-dotierte zweite Verbindungsgebiet 32 vor. Die zwischen den beiden Verbindungsgebieten 22 und 32 angeordnete Zwischenzone 54 ist nicht absolut notwendig. Sie erleichtert bei der Implantation lediglich die Einstellung der benachbarten Dotierungsprofile mit jeweils unterschiedlichem Leitungstyp.

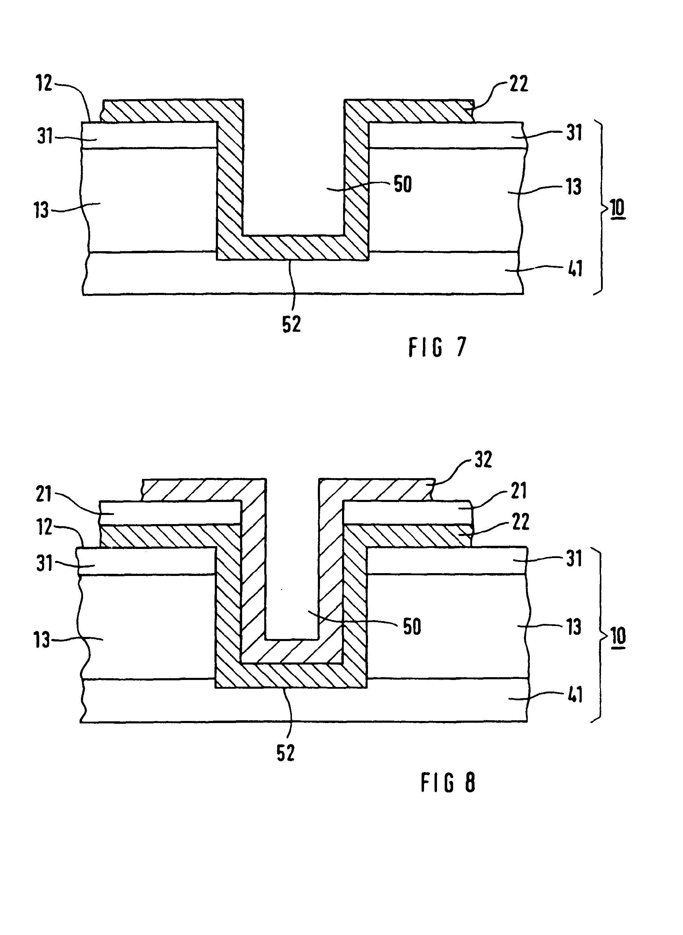

In den Figuren 7 und 8 ist ein alternatives Herstellungsverfahren der beiden Verbindungsgebiete 22 und 32 dargestellt. Ausgehend von dem in Figur 2 gezeigten Grundkörper wird das erste Verbindungsgebiet 22 unmittelbar in Form einer n-dotierten Epitaxieschicht aufgebracht (Figur 7). Es schließt sich das epitaktische Aufwachsen des Source-Kontaktgebiets 21 an. Danach wird das zweite Verbindungsgebiet 32 in Form einer p-dotierten Epitaxieschicht aufgebracht. (Figur 8). Bei dieser Herstellungsmethode sind keine Implantationsschritte vorgesehen.

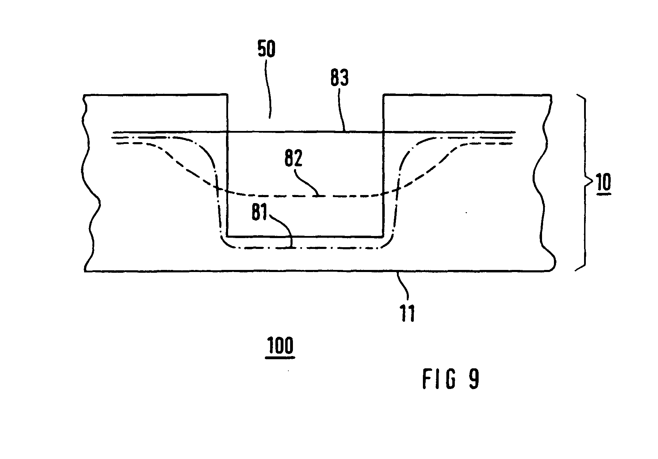

In Figur 9 ist von dem Sperrschicht-Feldeffekttransistor 100 der Halbleiterkörper 10 mit der Ausnehmung 50 dargestellt. In diese schematische Darstellung sind außerdem Äquipotentiallinien 81, 82 und 83 der elektrischen Feldstärke für verschiedene Sperrspannungen eingetragen. Eine erste Äquipotentiallinie 81 (strichpunktierte Linie)symbolisiert den Verlauf der elektrischen Feldstärke für eine niedrige Sperrspannung (≤ 0,1·Uₘₐₓ). Eine zweite Äquipotentiallinie 82 (gestrichelte Linie) gibt den Feldverlauf für eine mittlere Sperrspannung (0,2·Uₘₐₓ bis 0,6·Uₘₐₓ) wieder. Eine dritte Äquipotentiallinie 83 (durchgezogene Linie), die im wesentlichen parallel zur ersten Oberfläche 11 des Halbleiterkörpers 10 verläuft, zeigt schließlich die Feldverhältnisse für eine hohe Sperrspannung (0,7·Uₘₐₓ bis 1·Uₘₐₓ). Aus dem Verlauf der dritten Äquipotentiallinie 83 wird deutlich, daß die in Figur 9 nicht dargestellten ersten und zweiten Verbindungsgebiete 22 bzw. 32 keinen Einfluß auf das Sperrverhalten haben.

Es versteht sich, daß die angegebenen Leitungstyp aller genannten Halbleitergebiete auch jeweils vertauscht werden können.

## Patentansprüche

1. Sperrschicht-Feldeffekttransistor mit
a) einer Source-Elektrode (20), einer Gate-Elektrode (30) und einer Drain-Elektrode (40),
b) einem eine erste Oberfläche (11) aufweisenden Halbleiterbereich (10), der mindestens
b1) ein an der ersten Oberfläche (11) angeordnetes, die Drain-Elektrode (40) kontaktierendes Drain-Kontaktgebiet (41) eines ersten Leitungstyps,
b2) ein über dem Drain-Kontaktgebiet (41) angeordnetes Innengebiet (13) des ersten Leitungstyps und
b3) ein über dem Innengebiet (13) angeordnetes, von der Gate-Elektrode (30) kontaktiertes Steuergebiet (31) eines zweiten Leitungstyps aufweist,
c) und mit einem die Source-Elektrode (20) kontaktierenden Source-Kontaktgebiet (21) des ersten Leitungstyps, wobei das Innengebiet (13) und das Steuergebiet (31) zumindest teilweise zwischen dem Source-Kontaktgebiet (21) und dem Drain-Kontaktgebiet (41) angeordnet sind,
**gekennzeichnet durch**
d) mindestens ein sich bis zum Drain-Kontaktgebiet (41) erstreckendes erstes Verbindungsgebiet (22) des ersten Leitungstyps, wobei das erste Verbindungsgebiet (22)
d1) höher dotiert ist als das Innengebiet (13),
d2) mit dem Source-Kontaktgebiet (21) niederohmig direkt verbunden ist und
d3) zumindest einen inneren Teil (221) aufweist, der innerhalb des Halbleiterbereichs (10) annähernd senkrecht zur ersten Oberfläche (11) verläuft,
e) und mindestens ein zweites Verbindungsgebiet (32) des zweiten Leitungstyps, wobei
e1) zumindest ein innerer Teil (321) des zweiten Verbindungsgebiets (32) innerhalb des Halbleiterbereichs (10) annähernd senkrecht zur ersten Oberfläche (11) verläuft und
e2) die Dotierungskonzentration des inneren Teils (321) des zweiten Verbindungsgebiets (32) annähernd der Dotierungskonzentration des inneren Teils (221) des ersten Verbindungsgebiets (22) entspricht.

2. Sperrschicht-Feldeffekttransistor nach Anspruch 1, **dadurch gekennzeichnet, daß** in dem Halbleiterbereich (10) eine Ausnehmung (50) vorgesehen ist, die sich ausgehend von einer der ersten Oberfläche (11) gegenüberliegenden zweiten Oberfläche (12) des Halbleiterbereichs (10) in den Halbleiterbereich (10) erstreckt und innerhalb der die inneren Teile (221, 321) des ersten und des zweiten Verbindungsgebiets (22, 32) angeordnet sind, die senkrecht zur ersten Oberfläche (11) verlaufen.

3. Sperrschicht-Feldeffekttransistor nach Anspruch 2, **dadurch gekennzeichnet, daß** der innere Teil (221) des ersten Verbindungsgebiets (22) an Ränder (51, 52) der Ausnehmung (50) angrenzt.

4. Sperrschicht-Feldeffekttransistor nach einem der vorhergehenden Ansprüche, **dadurch gekennzeichnet, daß** jedem senkrecht zur ersten Oberfläche (11) verlaufenden inneren Teil (221) des ersten Verbindungsgebiets (22) ein dazu parallel verlaufender innerer Teil (321) des zweiten Verbindungsgebiets (32) zugeordnet ist.

5. Sperrschicht-Feldeffekttransistor nach Anspruch 4, **dadurch gekennzeichnet, daß** die einander zugeordneten inneren Teile (221, 321) des ersten und des zweiten Verbindungsgebiets (22, 32) direkt aneinandergrenzen.

6. Sperrschicht-Feldeffekttransistor nach einem der vorhergehenden Ansprüche, **dadurch gekennzeichnet, daß** zumindest der innere Teil (221) des ersten Verbindungsgebiets (22) eine der Durchbruchsladung zumindest weitgehend entsprechende Dotierungskonzentration aufweist.

7. Sperrschicht-Feldeffekttransistor nach einem der vorhergehenden Ansprüche, **dadurch gekennzeichnet, daß** der Halbleiterbereich (10), das erste und das zweite Verbindungsgebiet (22, 32) sowie das Source-Kontaktgebiet (21) aus Siliciumcarbid bestehen.

8. Sperrschicht-Feldeffekttransistor nach Anspruch 7, **dadurch gekennzeichnet, daß** zumindest der innere Teil (221) des ersten Verbindungsgebiets (22) bezogen auf eine zur ersten Oberfläche (11) senkrechte Fläche eine Dotierungskonzentration von höchstens 1·10¹³ cm⁻² aufweist.

9. Sperrschicht-Feldeffekttransistor nach einem der Ansprüche 1 bis 8, **dadurch gekennzeichnet, daß** der Halbleiterbereich (10), das erste und das zweite Verbindungsgebiet (22, 32) sowie das Source-Kontaktgebiet (21) aus Silicium bestehen.

10. Sperrschicht-Feldeffekttransistor nach Anspruch 9, **dadurch gekennzeichnet, daß** zumindest der innere Teil (221) des ersten Verbindungsgebiets (22) bezogen auf eine zur ersten Oberfläche (11) senkrechte Fläche eine Dotierungskonzentration von höchstens 1,5·10¹² cm⁻² aufweist.

11. Sperrschicht-Feldeffekttransistor nach einem der vorhergehenden Ansprüche, **dadurch gekennzeichnet, daß** das Steuergebiet (31) an einer der ersten Oberfläche (11) gegenüberliegenden zweiten Oberfläche (12) des Halbleiterbereichs (10) angeordnet ist.

12. Sperrschicht-Feldeffekttransistor nach einem der vorhergehenden Ansprüche, **dadurch gekennzeichnet, daß** die Gate-Elektrode (30) das Steuergebiet (31) und das zweite Verbindungsgebiet (32) ohmsch kontaktiert.

13. Sperrschicht-Feldeffekttransistor nach einem der vorhergehenden Ansprüche, **dadurch gekennzeichnet, daß** ein äußerer Teil (223) des ersten Verbindungsgebiets (22) auf dem Halbleiterbereich (10) über dem Steuergebiet (31) und das Source-Kontaktgebiet (21) auf dem äußeren Teil (223) des ersten Verbindungsgebiets (22) angeordnet sind sowie ein äußerer Teil (323) des zweiten Verbindungsgebiets (32) das Source-Kontaktgebiet (21) teilweise bedeckt, so daß sich bei einer Projektion senkrecht zur ersten Oberfläche (11) die Projektion des Steuergebiets (31) und die Projektion des äußeren Teils (323) des zweiten Verbindungsgebiets (32) überlappen.

## Claims

1. Junction field-effect transistor comprising
a) a source electrode (20), a gate electrode (30) and a drain electrode (40),
b) a semiconductor region (10) having a first surface (11) and having at least
b1) a drain contact region (41) of a first conduction type arranged on the first surface (11) and making contact with the drain electrode (40),
b2) an inner region (13) of the first conduction type arranged above the drain contact region (41), and
b3) a control region (31) of a second conduction type arranged above the inner region (13), contact being made with said control region by the gate electrode (30),
c) and comprising a source contact region (21) of the first conduction type making contact with the source electrode (20), the inner region (13) and the control region (31) being arranged at least partly between the source contact region (21) and the drain contact region (41),
**characterized by**
d) at least one first connecting region (22) of the first conduction type extending as far as the drain contact region (41), the first connecting region (22)
d1) being doped more highly than the inner region (13),
d2) being directly connected to the source contact region (21) in a low-impedance manner, and
d3) having at least one inner part (221) running within the semiconductor region (10) approximately perpendicularly to the first surface (11),
e) and at least one second connecting region (32) of the second conduction type,
e1) at least one inner part (321) of the second connecting region (32) running within the semiconductor region (10) approximately perpendicularly to the first surface (11), and
e2) the doping concentration of the inner part (321) of the second connecting region (32) approximately corresponding to the doping concentration of the inner part (221) of the first connecting region (22).

2. Junction field-effect transistor as claimed in Claim 1, **characterized in that** a recess (50) is provided in the semiconductor region (10), which recess, proceeding from a second surface (12) - opposite to the first surface (11) - of the semiconductor region (10), extends into the semiconductor region (10) and within which recess the inner parts (221, 321) of the first and of the second connecting region (22, 32) are arranged, which run perpendicularly to the first surface (11).

3. Junction field-effect transistor as claimed in Claim 2, **characterized in that** the inner part (221) of the first connecting region (22) adjoins edges (51, 52) of the recess (50).

4. Junction field-effect transistor as claimed in one of the preceding claims, **characterized in that** each inner part (221) - running perpendicularly to the first surface (11) - of the first connecting region (22) is assigned an inner part (321) - running parallel thereto - of the second connecting region (32).

5. Junction field-effect transistor as claimed in Claim 4, **characterized in that** the mutually assigned inner parts (221, 321) of the first and of the second connecting region (22, 32) directly adjoin one another.

6. Junction field-effect transistor as claimed in one of the preceding claims, **characterized in that** at least the inner part (221) of the first connecting region (22) has a doping concentration which at least largely corresponds to the breakdown charge.

7. Junction field-effect transistor as claimed in one of the preceding claims, **characterized in that** the semiconductor region (10), the first and the second connecting region (22, 32) and also the source contact region (21) are composed of silicon carbide.

8. Junction field-effect transistor as claimed in Claim 7, **characterized in that** at least the inner part (221) of the first connecting region (22) has a doping concentration of at most 1·10¹³ cm⁻² relative to an area perpendicular to the first surface (11).

9. Junction field-effect transistor as claimed in one of Claims 1 to 8, **characterized in that** the semiconductor region (10), the first and the second connecting region (22, 32) and also the source contact region (21) are composed of silicon.

10. Junction field-effect transistor as claimed in Claim 9, **characterized in that** at least the inner part (221) of the first connecting region (22) has a doping concentration of at most 1.5·10¹² cm⁻² relative to an area perpendicular to the first surface (11).

11. Junction field-effect transistor as claimed in one of the preceding claims, **characterized in that** the control region (31) is arranged on a second surface (12) of the semiconductor region (10), said second surface being opposite to the first surface (11).

12. Junction field-effect transistor as claimed in one of the preceding claims, **characterized in that** the gate electrode (30) makes ohmic contact with the control region (31) and the second connecting region (32).

13. Junction field-effect transistor as claimed in one of the preceding claims, **characterized in that** an outer part (223) of the first connecting region (22) is arranged on the semiconductor region (10) above the control region (31) and the source contact region (21) is arranged on the outer part (223) of the first connecting region (22), and an outer part (323) of the second connecting region (32) partly covers the source contact region (21), with a result that, in the event of a projection perpendicular to the first surface (11), the projection of the control region (31) and the projection of the outer part (323) of the second connecting region (32) overlap.

## Revendications

1. Transistor à effet de champ à jonction de grille comprenant
a) une électrode de source (20), une électrode de grille (30) et une électrode de drain (40),
b) une zone de semi-conducteur (10) présentant une première surface (11), qui présente au moins
b1) une zone de contact de drain (41) d'un premier type de conductivité, disposée sur la première surface (11) et mettant en contact l'électrode de drain (40),
b2) une zone intérieure (13) du premier type de conductivité, disposée au-dessus de la zone de contact de drain (41) et
b3) une zone de commande (31) d'un second type de conductivité, disposée au-dessus de la zone intérieure (13) et mise en contact par l'électrode de grille (30),
c) et comprenant une zone de contact de source (21) du premier type de conductivité, mettant en contact l'électrode de source (20), la zone intérieure (13) et la zone de commande (31) étant disposées au moins partiellement entre la zone de contact de source (21) et la zone de contact de drain (41),
**caractérisé par**
d) au moins une première zone de connexion (22) du premier type de conductivité, s'étendant jusqu'à la zone de contact de drain (41), la première zone de connexion (22)
d1) étant dopée de manière plus haute que la zone intérieure (13)
d2) étant raccordée directement à faible résistance à la zone de contact de source (21) et
d3) présentant au moins une partie intérieure (221) qui s'étend à l'intérieur de la zone de semi-conducteur (10), approximativement perpendiculairement à la première surface (11),
e) et au moins une seconde zone de connexion (32) du second type de conductivité,
e1) au moins une partie intérieure (321) de la seconde zone de connexion (32) s'étendant à l'intérieur de la zone de semi-conducteur (10), approximativement perpendiculairement à la première surface (11) et
e2) la concentration de dopage de la partie intérieure (321) de la seconde zone de connexion (32) correspondant approximativement à la concentration de dopage de la partie intérieure (221) de la première zone de connexion (22).

2. Transistor à effet de champ à jonction de grille selon la revendication 1, **caractérisé en ce qu'**un évidement (50) est ménagé dans la zone de semi-conducteur (10), lequel, en partant d'une seconde surface (12), opposée à la première surface (11), de la zone de semi-conducteur (10), s'étend dans la zone de semi-conducteur (10) et à l'intérieur duquel sont disposées les parties intérieures (221, 321) de la première et de la seconde zones de connexion (22, 32), qui s'étendent perpendiculairement à la première surface (11).

3. Transistor à effet de champ à jonction de grille selon la revendication 2, **caractérisé en ce que** la partie intérieure (221) de la première zone de connexion (22) est adjacente à des bords (51, 52) de l'évidement (50).

4. Transistor à effet de champ à jonction de grille selon l'une quelconque des revendications précédentes, **caractérisé en ce qu'**à chaque partie intérieure (221) de la première zone de connexion (22), s'étendant perpendiculairement à la première surface (11), est affectée une partie intérieure (321) de la seconde zone de connexion (32), s'étendant parallèlement à la partie intérieure (221).

5. Transistor à effet de champ à jonction de grille selon la revendication 4, **caractérisé en ce que** les parties intérieures (221, 321), affectées l'une à l'autre, de la première et de la seconde zones de connexion (22, 32) sont directement adjacentes l'une à l'autre.

6. Transistor à effet de champ à jonction de grille selon l'une quelconque des revendications précédentes, **caractérisé en ce qu'**au moins la partie intérieure (221) de la première zone de connexion (22) présente une concentration de dopage correspondant au moins considérablement à la charge de claquage.

7. Transistor à effet de champ à jonction de grille selon l'une quelconque des revendications précédentes, **caractérisé en ce que** la zone de semi-conducteur (10), la première et la seconde zones de connexion (22, 32) ainsi que la zone de contact de source (21) sont constituées de carbure de silicium.

8. Transistor à effet de champ à jonction de grille selon la revendication 7, **caractérisé en ce qu'**au moins la partie intérieure (221) de la première zone de connexion (22) présente, par rapport à une surface perpendiculaire à la première surface (11), une concentration de dopage de maximum 1 · 10¹³ cm⁻².

9. Transistor à effet de champ à jonction de grille selon l'une quelconque des revendications 1 à 8, **caractérisé en ce que** la zone de semi-conducteur (10), la première et la seconde zones de connexion (22, 32) ainsi que la zone de contact de source (21) sont constituées de silicium.

10. Transistor à effet de champ à jonction de grille selon la revendication 9, **caractérisé en ce qu'**au moins la partie intérieure (221) de la première zone de connexion (22) présente, par rapport à une surface perpendiculaire à la première surface (11), une concentration de dopage de maximum 1,5 · 10¹² cm⁻².

11. Transistor à effet de champ à jonction de grille selon l'une quelconque des revendications précédentes, **caractérisé en ce que** la zone de commande (31) est disposée sur une seconde surface (12), opposée à la première surface (11), de la zone de semi-conducteur (10).

12. Transistor à effet de champ à jonction de grille selon l'une quelconque des revendications précédentes, **caractérisé en ce que** l'électrode de grille (30) met en contact la zone de commande (31) et la seconde zone de connexion (32) de manière ohmique.

13. Transistor à effet de champ à jonction de grille selon l'une quelconque des revendications précédentes, **caractérisé en ce qu'**une partie extérieure (223) de la première zone de connexion (22) est disposée sur la zone de semi-conducteur (10) au-dessus de la zone de commande (31) et **en ce que** la zone de contact de source (21) est disposée sur la partie extérieure (223) de la première zone de connexion (22) et **en ce qu'** une partie extérieure (323) de la seconde zone de connexion (32) recouvre partiellement la zone de contact de source (21), de sorte qu'en cas de projection perpendiculairement à la première surface (11), la projection de la zone de commande (31) et la projection de la partie extérieure (323) de la seconde zone de connexion (32) se chevauchent.
